# EUROPÄISCHE PATENTSCHRIFT

(11) **EP 1 475 458 B1**
(45) Veröffentlichungstag und Bekanntmachung des Hinweises auf die Patenterteilung: **25.02.2015**
(21) Anmeldenummer: 04006860.3
(22) Anmeldetag: 22.03.2004
(51) Int. Cl.: H01J 37/32, C23C 14/56, H01J 37/34

(54) **Vorrichtung zum Beschichten eines Substrats.**
Apparatus for coating a substrate.
Dispositif pour le revêtement d'un substrat.

(30) Priorität: 09.05.2003 DE 10320985
(43) Veröffentlichungstag der Anmeldung: 10.11.2004
(73) Patentinhaber: INTERPANE Entwicklungs- und Beratungsgesellschaft mbH, 37697 Lauenförde (DE)
(72) Erfinder: Landgraf, Ralf, 94469 Deggendorf (DE); Herwig, Wilhelm, 37688 Beverungen (DE)
(74) Vertreter: Körfer, Thomas

(56) Entgegenhaltungen:
- EP-A- 0 783 174
- US-A- 3 852 181
- US-A- 5 065 698

## Beschreibung

Die Erfindung bezieht sich auf eine Vorrichtung zum Beschichten eines Substrats nach dem Oberbegriff des Anspruchs 1.

Beispielsweise ist aus der EP 0 783 174 A2 eine Vorrichtung gemäß dem Oberbegriff des Anspruchs 1 bekannt. Bei der dort beschriebenen Vorrichtung zum Beschichten eines Substrats mit einer Wechselstromquelle, die mit zwei Kathoden verbunden ist, ist der eine Pol der Wechselstromquelle an die eine Kathode und der andere Pol an die andere Kathode über Versorgungsleitungen angeschlossen, wobei jede der beiden Kathoden in einem eigenen Abteil einer Vielzahl von benachbart angeordneten, zusammen eine Vakuumkammer bildenden, über einen Durchgang miteinander verbundenen Abteilen vorgesehen ist, wobei die beiden die mit der Wechselstromquelle verbundenen Kathoden aufweisenden Abteile durch mehrere Abteile, die zumindest teilweise mit je einer weiteren Sputterkathode mit separater Stromversorgung ausgestattet sind, voneinander abgetrennt angeordnet sind.

Weiterhin ist aus der DE 100 04 786 A1 eine Vakuumbeschichtungsanlage zum Beschichten plattenförmiger Substrate mit mehreren nebeneinander angeordneten Sektionen, die über Schleusen miteinander verbunden und über Saugöffnungen evakuierbar sind, mit mehreren Vakuumpumpen und mit einer Einrichtung zum Transport des Substrates durch die Sektionen, bekannt. Dabei weist eine der Sektionen eine Saugöffnung und an ihrem oberen Wandteil eine Öffnung auf, die mit einem auf dem Rand der Öffnung aufliegendem Deckel verschlossen ist, an dem wahlweise ein Magnetron oder mehrere Magnetrons befestigt sind, die mindestens ein Magnetsystem und ein Target umfassen und die so in den Innenraum der Sektion ragen, daß ihre Targets über dem Substrat liegen. Die Saugöffnung ist direkt oder mit einem Schlauch- oder Rohrsystem mit einer Vakuumpumpe verbunden und oberhalb des Targets im Deckel angeordnet.

Nachteilig an den aus den oben genannten Druckschriften bekannten Vorrichtungen ist insbesondere, daß bedingt durch die lokalisierten Austrittsöffnungen der Vakuumpumpen kein homogenes Vakuum geschaffen wird, sondern in der Nähe der Austrittsöffnungen der Vakuumpumpen der Druck niedriger ist als abgelegen von den Austrittsöffnungen. Dies führt zu einem inhomogenen Druckprofil senkrecht zur Transportrichtung der Substrate. In der Folge treten in den einzelnen Schichten der Beschichtung ebenfalls Inhomogenitäten auf, da die freie Weglänge der gesputterten Atome in dem Vakuum und somit die Sputterrate von dem lokalen Druck abhängt. Diese Inhomogenitäten führen zu einem Qualitätsverlust bei der Schichtgüte.

Der Erfindung liegt daher die Aufgabe zu Grunde, das Vakuum so zu beeinflussen, daß es homogen ist.

Die Aufgabe wird durch die Merkmale des Anspruchs 1 gelöst.

Bei der erfindungsgemäß ausgestalteten Vorrichtung ist ein sich quer zur Transportrichtung der Substrate erstreckender Saugraum zwischen der Vakuumkammer und der Vakuumpumpe ausgebildet, welcher über zumindest eine Drosselstelle gedrosselt mit der Vakuumkammer in Verbindung steht. Durch eine entsprechende Auslegung der Drosselstelle ist eine gleichmäßige Absaugung entlang der Breitenerstreckung der Vakuumkammer möglich, wodurch das Druckprofil über den gesamten Beschichtungsbereich homogenisiert wird. Inhomogenitäten durch die lokalisierte Anordnung der Pumpen treten nicht in der Vakuumkammer, sondern erst im Saugraum auf, wodurch die Beschichtung nicht beeinflußt wird.

Vorteilhafte Weiterbildungen der Erfindung sind in den Unteransprüchen beschrieben.

Vorteilhafterweise erstrecken sich Saugraum und die Drosselstelle bildende Schlitze über die gesamte verfügbare Breite der Vakuumkammer, so daß Inhomogenitäten in der Gasverteilung effektiv vermieden werden können.

Von Vorteil ist weiter, daß der Saugraum mittels eines Winkelelements, welcher mit der Vakuumpumpe in Verbindung steht, und einer entsprechend geformten kastenförmigen Anordnung, welche im Falle der Sputterkammer die Kathodenanordnung enthalten kann, gebildet wird.

Vorteilhafterweise wird der Saugraum in den Pumpkammern durch einfache, aus Winkelblechen zusammengesetzten kastenförmige Anordnungen gebildet.

Die Schlitzweite ist vorteilhafterweise bei der Montage so einstellbar, daß ein Drosseleffekt auftritt, der die Homogenisierung der Gasverteilung in der Vakuumkammer bewirkt.

Nachfolgend werden vorteilhafte Ausgestaltungen der Erfindung anhand bevorzugter Ausführungsbeispiele und der Zeichnung näher erläutert. Es zeigen:
- Fig. 1: eine schematische, geschnittene seitliche Darstellung eines Ausführungsbeispiels einer erfindungsgemäß ausgestalteten Vorrichtung zur Beschichtung eines Substrates,
- Fig. 2A: einen Schnitt quer zur Transportrichtung des Substrates eines Ausführungsbeispiels einer Sputterkammer zur Verwendung in einer Vorrichtung gemäß Fig. 1 mit zwei Vakuumpumpen,
- Fig. 2B: einen Schnitt quer zur Transportrichtung des Substrates eines Ausführungsbeispiels einer Pumpkammer zur Verwendung in eine Vorrichtung gemäß Fig. 1 mit nur einer Vakuumpumpe,
- Fig. 3A: eine vergrößerte, geschnittene Ansicht der in Fig. 1 mit S bezeichneten Sputterkammer der erfindungsgemäß ausgestalteten Vorrichtung, und
- Fig. 3B-C: eine vergrößerte, geschnittene Ansicht der in Fig. 1 mit P1 und P2 bezeichneten Pumpkammern der erfindungsgemäß ausgestalteten Vorrichtung in zwei verschiedenen Ausgestaltungen.

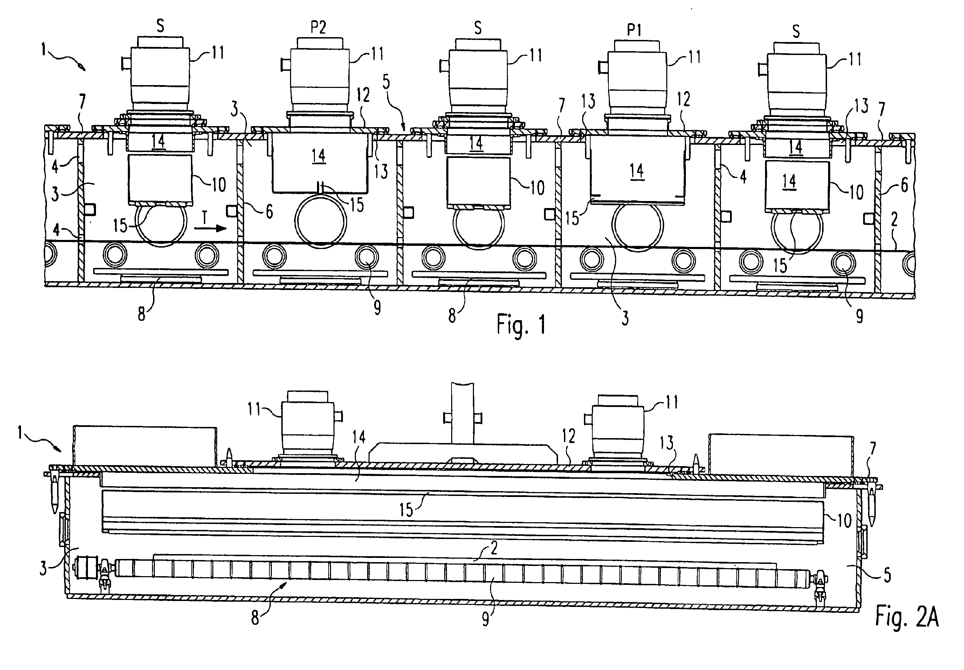

Fig. 1 zeigt in einer schematischen Schnittansicht ein Ausführungsbeispiel einer erfindungsgemäß ausgestalteten Vorrichtung 1 zur Beschichtung eines Substrates 2 in einer seitlichen Gesamtansicht.

Eine derartige Vorrichtung 1 dient zum Beschichten eines Substrats 2 wie z. B. Glas mit verschiedenen Beschichtungen wie z. B. Wärmeschutzschichten oder Sonnenschutzschichten.

Die Vorrichtung 1 umfaßt dabei mehrere, im dargestellten Ausführungsbeispiel beispielsweise fünf Sektionen 3, welche durch mehrere Öffnungen 4 untereinander verbunden sind und in ihrer Gesamtheit eine Vakuumkammer 5 bilden. Die Öffnungen 4 sind in die Sektionen 3 voneinander trennenden Wänden 6 in Höhe des die Vakuumkammer 5 durchlaufenden Substrats 2 sowie beispielsweise nahe einem Deckel 7 der Vakuumkammer 5 ausgebildet.

Das Substrat 2 wird mittels geeigneter, nicht näher beschriebener Transportvorrichtungen 8, welche beispielsweise entsprechend geformte Rollen 9 aufweisen, durch die Sektionen 3 entlang einer Transportrichtung T transportiert.

Die Sektionen 3 sind im Ausführungsbeispiel abwechselnd als Sputterkammer S und Pumpkammer P1/P2 ausgelegt. Es ist also im Ausführungsbeispiel nur in jeder zweiten Sektion 3 eine Kathodenanordnung 10 angeordnet, während die dazwischenliegenden Sektionen 3 zur Trennung der Beschichtungsprozesse dienen.

Die Evakuierung der Vakuumkammer 5 wird durch oberhalb der Vakuumkammer 5 angeordnete Vakuumpumpen 11 erzielt. Diese sind im vorliegenden Ausführungsbeispiel auf Deckplatten 12 angeordnet, welche auf dem Deckel 7 aufliegen und die in diesem vorhandenen Saugöffnungen 13 verschließen. Unterhalb der Saugöffnungen 13 ist erfindungsgemäß ein Saugraum 14 ausgebildet, welcher sich quer zur Transportrichtung T des Substrats 2 über die gesamte Breite des zu beschichtenden Substrats 2 erstreckt.

Bekannte Vorrichtungen 1 zum Beschichten eines Substrats 2 weisen bedingt durch die Anordnung der Vakuumpumpen 11 eine inhomogene Druckverteilung in der Vakuumkammer 5 auf, wodurch die auf das Substrat 2 aufgebrachten Beschichtungen in der Schichtdicke bedingt durch die inhomogene Druckverteilung variieren. Die Qualität der Beschichtungen ist somit stark eingeschränkt. Insbesondere bildet sich bei einer Anordnung der Vakuumpumpen 11 wie in Fig. 2A dargestellt ein mehr oder weniger stark ausgeprägter M-förmiger Verlauf in der Schichtdicke über die Breite des Substrates 2, was dadurch hervorgerufen wird, daß die beiden Vakuumpumpen 11 in den direkt darunterliegenden Bereichen der Vakuumkammer 11 kurzzeitig eine höhere Gaskonzentration bzw. an den Seiten ein stärkeres Vakuum ausbilden. Dies wird durch die Trennung der Sektionen 3 durch die Wände 6 noch verstärkt, da der Gasaustausch durch die Öffnungen 4 nur eingeschränkt möglich ist.

Zur Homogenisierung der Gasverteilung in der Vakuumkammer 5 ist daher erfindungsgemäß vorgesehen, durch die Vorschaltung des Saugraumes 14 vor die Vakuumpumpe 11 und eine entsprechende Ausgestaltung der drosselnden Einlässe bzw. Drosselstellen 15 aus der Vakuumkammer 5 in den Saugraum 14 eine über die gesamte zu beschichtende Breite des Substrates 2 gleichmäßige Gasverteilung zu erzeugen. Die Drosselstellen 15 sind dabei vorzugsweise in Form von Schlitzen 15 ausgebildet, welche sich vorzugsweise über die gesamte Breite des Saugraumes 14 erstrecken und so dimensioniert sind, daß die Saugleistung der Vakuumpumpen 11 die die Schlitze 15 durchströmende Gasmenge übersteigt, die Schlitze 15 also eine Drosselwirkung ausüben. Durch diese Drosselwirkung sowie durch die Länge der Schlitze 15 kann sichergestellt werden, daß eine auf gesamter Breite der Vakuumkammer 5 gleichmäßige Strömung durch die Pumpwirkung der Vakuumpumpen 11 erzielt wird, so daß die Inhomogenisierung der Gasverteilung auf den Saugraum 14 beschränkt ist.

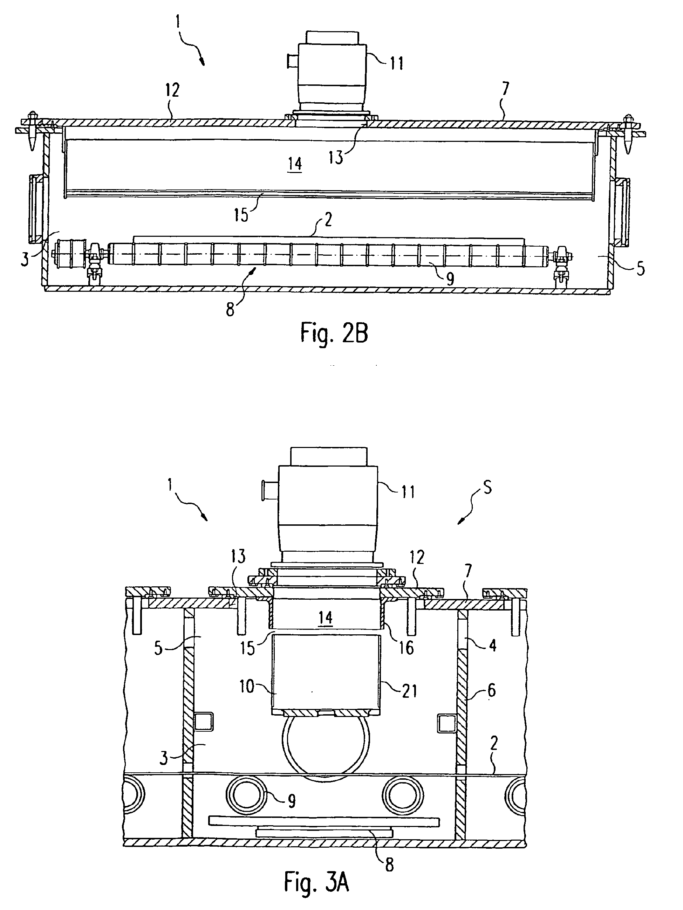

Auf die beispielhafte Form und Ausführung des Saugraums 14 und der Schlitze 15 wird unter Bezugnahme auf die Fig. 3A bis 3C weiter unten näher eingegangen.

In den Fig. 2A und 2B sind Ausführungsbeispiele für eine Sputterkammer S sowie für eine Pumpkammer P1 in einer Blickrichtung parallel zur Führung des Substrates 2 dargestellt. Dabei weist das in Fig. 2A dargestellte Ausführungsbeispiel der Sputterkammer S zwei Vakuumpumpen 11 auf, während das in Fig. 2B dargestellte Ausführungsbeispiel der Pumpkammer P1 lediglich eine Vakuumpumpe 11 aufweist. Insbesondere letztere Ausführungsform ist anfällig gegenüber der Inhomogenisierung der Gasverteilung in der Vakuumkammer 5, wie weiter oben beschrieben, wobei sich in diesem Fall eine glockenförmige Verteilung bei der Dicke der Beschichtung auf dem Substrat 2 bildet. Sowohl die Ausführungsform mit einer als auch eine mit mehreren Vakuumpumpen 11 ist zur Verwendung mit den erfindungsgemäßen Maßnahmen geeignet.

Aus den Fig. 2A und 2B ist insbesondere ersichtlich, daß sich die Saugräume 14 und die Schlitze 15 nicht nur über die gesamte Breite des zu beschichtenden Substrates 2, sondern sich über fast die gesamte nutzbare Breite der Vakuumkammer 5 erstrecken. Dadurch kann sichergestellt werden, daß die Gasverteilung im Bereich des Substrats 2 eine größtmögliche Homogenität erreicht und geringfügige Inhomogenitäten der Gasverteilung in den Randbereichen der Vakuumkammer 5 ohne Einfluß auf die Gasverteilung über dem Substrat 2 bleibt.

Fig. 3A zeigt ein Ausführungsbeispiel einer erfindungsgemäß ausgestalteten Sputterkammer S gemäß Fig. 1.

Wie bereits weiter oben erläutert, ist zwischen der Vakuumpumpe 11 und der Kathodenanordnung 10 ein Saugraum 14 vorgesehen, welcher. über Schlitze 15 Gas aus der Vakuumkammer 5 absaugt. Die Schlitze 15 sind dabei so bemessen, daß die Pumpleistung der Vakuumpumpe 11 höher als die durch die Schlitze 15 strömende Gasmenge ist, wodurch eine Drosselwirkung erzielt wird. Die Schlitze 15 sind im vorliegend beschriebenen Ausführungsbeispiel einer Sputterkammer S zwischen der Wandung 21 und der Kathodenanordnung 10, welche eine in etwa kastenförmige Form aufweist, und einem Winkelelement 16, welcher die Saugöffnung 13 durchgreift und mit der Vakuumpumpe 11 dichtend montiert ist, ausgebildet. Die Kathodenanordnung 10 wird dabei beispielsweise durch nicht näher dargestellte Halteklammern an dem Winkelelement 16 in ihrer Position fixiert.

Zur gleichmäßigen Gasverteilung in der Vakuumkammer 5 ist es zweckmäßig, auch in den Pumpkammern P1 und P2 eine homogene Gasverteilung herzustellen, um zu verhindern, daß durch den Gasausgleich durch die Öffnungen 4 die Homogenität des Druckprofils in der Sputterkammer S beeinflußt wird.

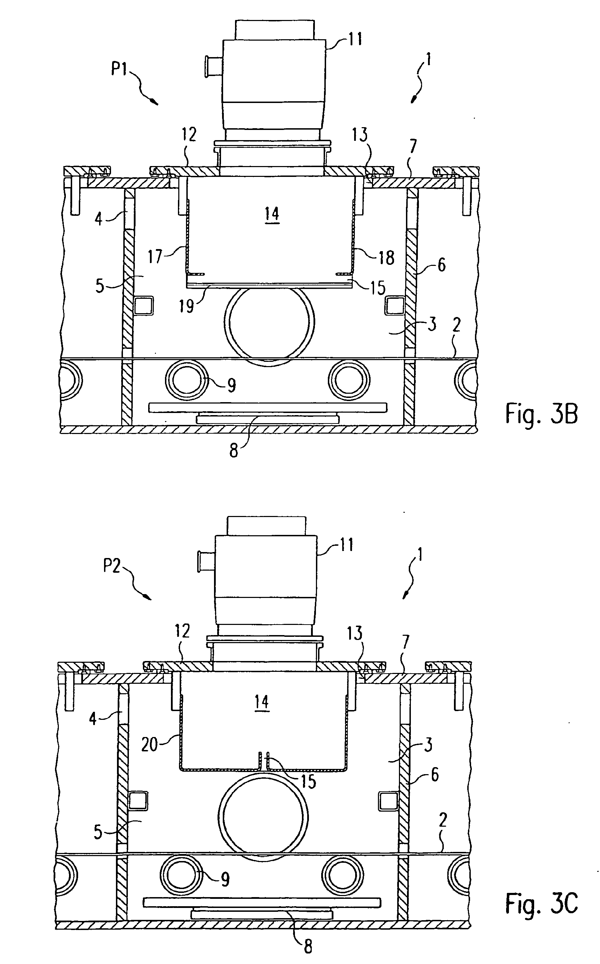

Fig. 3B zeigt ein erstes Ausführungsbeispiel einer erfindungsgemäß ausgestalteten Pumpkammer P1 gemäß Fig. 1.

Hierbei wird statt der Kathodenanordnung 10 eine ebenfalls in etwa kastenförmige Anordnung 17 unterhalb der Vakuumpumpe 11 in der Vakuumkammer 5 angeordnet. Diese steht ebenfalls über das Winkelelement 16 mit der Vakuumpumpe 11 in Verbindung.

Die Schlitze 15 sind dabei an der Unterseite der Anordnung 17 ausgebildet, indem Seitenbleche 18, welche die Stirnseiten der kastenförmigen Anordnung 17 bilden, nach innen umgebogen sind. Die Schlitze 15 sind somit den Wänden 6 der Sektionen 3 zugewandt. Die Anordnung 17 ist einfach herstellbar und montierbar. Die Weite der Schlitze 15 kann bei der Herstellung der Seitenbleche 18 eingestellt und durch die Position eines Deckels 19 relativ zu den Seitenwänden 18 verändert werden.

Fig. 3C zeigt ein zweites Ausführungsbeispiel einer erfindungsgemäß ausgestalteten Pumpkammer P2 gemäß Fig. 1.

Im Gegensatz zu dem in Fig. 3B dargestellten Ausführungsbeispiel ist die Anordnung 17 in der Pumpkammer P2 nur mit einem Schlitz 15 versehen, welcher dem Substrat 2 zugewandt ist. Dadurch kann die Herstellung der Anordnung 17 vereinfacht werden, indem zwei Winkelbleche 20 zusammengesetzt werden. Der Schlitz 15 ist durch eine passende Beabstandung der beiden Winkelbleche 20 zueinander einstellbar.

Die Erfindung ist nicht auf die dargestellten Ausführungsbeispiele beschränkt. Sämtliche Merkmale der einzelnen Ausführungsbeispiele sind beliebig miteinander kombinierbar.

## Patentansprüche

1. Vorrichtung (1) zum Beschichten eines Substrats (2), umfassend eine Vakuumkammer (5), zumindest eine in der Vakuumkammer (5) angeordnete Kathodenanordnung (10) und zumindest eine mit der Vakuumkammer (5) in Verbindung stehende Vakuumpumpe (11), wobei zwischen der zumindest einen Vakuumpumpe (11) und der Vakuumkammer (5) ein Saugraum (14) ausgebildet ist,
**dadurch gekennzeichnet,**
**dass** sich der Saugraum (14) quer zu einer Transportrichtung (T) des Substrats (2) erstreckt, wobei der Saugraum (14) über zumindest eine Drosselstelle gedrosselt mit der Vakuumkammer (5) in Verbindung steht, und
**dass** die Drosselstelle durch zumindest einen sich quer zur Transportrichtung des Substrats (2) erstreckenden Schlitz (15) gebildet ist, wobei der Schlitz (15) so einstellbar ist, dass ein Drosseleffekt auftritt, der eine Homogenisierung der Gasverteilung in der Vakuumkammer (5) bewirkt.

2. Vorrichtung nach Anspruch 1,
**dadurch gekennzeichnet,**
**dass** die Vakuumkammer (5) in mehrere Sektionen (3) aufgeteilt ist.

3. Vorrichtung nach Anspruch 2,
**dadurch gekennzeichnet,**
**dass** zumindest eine der Sektionen (3) als Sputterkammer (S) ausgebildet ist.

4. Vorrichtung nach Anspruch 2 oder 3,
**dadurch gekennzeichnet,**
**dass** zumindest eine der Sektionen (3) als Pumpkammer (P1, P2) ausgebildet ist.

5. Vorrichtung nach einem der Ansprüche 2 bis 4,
**dadurch gekennzeichnet,**
**dass** die Sektionen (3) durch Wände (6) voneinander getrennt sind.

6. Vorrichtung nach Anspruch 5,
**dadurch gekennzeichnet,**
**dass** die Wände (6) Öffnungen (4) aufweisen.

7. Vorrichtung nach einem der Ansprüche 1 bis 6,
**dadurch gekennzeichnet,**
**dass** sich der Saugraum (14) über eine Gesamtbreite der Vakuumkammer (5) erstreckt.

8. Vorrichtung nach Anspruch 1,
**dadurch gekennzeichnet,**
**dass** sich der zumindest eine Schlitz (15) über eine Gesamtbreite des Saugraums (14) erstreckt.

9. Vorrichtung nach einem der Ansprüche 1 bis 8,
**dadurch gekennzeichnet,**
**dass** die zumindest eine Vakuumpumpe (11) auf zumindest einer Deckplatte (12) montiert ist.

10. Vorrichtung nach Anspruch 9,
**dadurch gekennzeichnet,**
**dass** die zumindest eine Deckplatte (12) jeweils eine Saugöffnung (13) in einem Deckel (7) der Vakuumkammer (5) abdeckt.

11. Vorrichtung nach Anspruch 10,
**dadurch gekennzeichnet,**
**dass** an der zumindest einen Deckplatte (12) ein Winkelelement (16) ausgebildet ist.

12. Vorrichtung nach Anspruch 11,
**dadurch gekennzeichnet,**
**dass** das Winkelelement (16) die jeweilige Saugöffnung (13) durchgreift.

13. Vorrichtung nach einem der Anspruch 3,
**dadurch gekennzeichnet,**
**dass** in der Sputterkammer (S) die Kathodenanordnung (10) so angeordnet ist, dass sich zumindest ein Schlitz (15) und ein Saugraum (14) zwischen der Kathodenanordnung (10) und der Vakuumpumpe (11) ausbildet.

14. Vorrichtung nach Anspruch 13,
**dadurch gekennzeichnet,**
**dass** der zumindest eine Schlitz (15) zwischen einem mit einer Deckplatte (12) verbundenen Winkelelement (16) und einer Wandung (21) der Kathodenanordnung (10) ausgebildet ist.

15. Vorrichtung nach einem der Anspruch 4,
**dadurch gekennzeichnet,**
**dass** in der Pumpkammer (P1, P2) eine Anordnung (17) unter Ausbildung von zumindest einem Schlitz (15) und einem Saugraum (14) angeordnet ist.

16. Vorrichtung nach Anspruch 15,
**dadurch gekennzeichnet,**
**dass** die Anordnung (17) kastenförmig ausgebildet ist.

17. Vorrichtung nach Anspruch 16,
**dadurch gekennzeichnet,**
**dass** die Anordnung (17) Seitenbleche (18) und einen Deckel (19) aufweist.

18. Vorrichtung nach Anspruch 17,
**dadurch gekennzeichnet,**
**dass** die Schlitze (15) zwischen dem Deckel (19) und den nach innen gebogenen Seitenblechen (18) ausgebildet sind.

19. Vorrichtung nach Anspruch 18,
**dadurch gekennzeichnet,**
**dass** die Schlitze (15) in Richtung der Wände (6) der Pumpkammer (P1) orientiert sind.

20. Vorrichtung nach Anspruch 19,
**dadurch gekennzeichnet,**
**dass** die Anordnung (17) aus zwei Winkelblechen (20) aufgebaut ist.

21. Vorrichtung nach Anspruch 20,
**dadurch gekennzeichnet,**
**dass** die Winkelbleche (20) durch einen Schlitz (15) voneinander beabstandet sind.

22. Vorrichtung nach Anspruch 21,
**dadurch gekennzeichnet,**
**dass** der Schlitz (15) zwischen den Winkelblechen (20) in Richtung des Substrates (2) orientiert ist.

## Claims

1. Device (1) for coating a substrate (2), comprising a vacuum chamber (5), at least one cathode arrangement (10) arranged in the vacuum chamber (5), and at least one vacuum pump (11) in connection with the vacuum chamber (5), wherein a suction chamber (14) is formed between the at least one vacuum pump (11) and the vacuum chamber (5), **characterised in that** the suction chamber (14) extends transversely to a transport direction (T) of the substrate (2), the suction chamber (14) being in connection throttled by means of at least one throttling point with the vacuum chamber (5), and
**in that** the throttling point is formed by at least one slit (15) extending transversely to the transport direction of the substrate (2), the slit (15) being adjustable so that a throttling effect occurs which causes homogenisation of the gas distribution in the vacuum chamber (5).

2. Device according to claim 1,
**characterised in that** the vacuum chamber (5) is divided into a plurality of sections (3).

3. Device according to claim 2,
**characterised in that** at least one of the sections (3) takes the form of a sputter chamber (S).

4. Device according to claim 2 or 3,
**characterised in that** at least one of the sections (3) takes the form of a pump chamber (P1, P2).

5. Device according to one of claims 2 to 4,
**characterised in that** the sections (3) are separated from one another by walls (6).

6. Device according to claim 5,
**characterised in that** the walls (6) exhibit openings (4).

7. Device according to one of claims 1 to 6,
**characterised in that** the suction chamber (14) extends over a total width of the vacuum chamber (5).

8. Device according to claim 1,
**characterised in that** the at least one slit (15) extends over a total width of the suction chamber (14).

9. Device according to one of claims 1 to 8,
**characterised in that** the at least one vacuum pump (11) is mounted on at least one covering plate (12).

10. Device according to claim 9,
**characterised in that** the at least one covering plate (12) in each case covers a suction opening (13) in a cover (7) of the vacuum chamber (5).

11. Device according to claim 10,
**characterised in that** an angle element (16) is formed on the at least one covering plate (12).

12. Device according to claim 11,
**characterised in that** the angle element (16) engages through the respective suction opening (13).

13. Device according to one of claim 3,
**characterised in that** the cathode arrangement (10) is arranged in the sputter chamber (S) so that at least one slit (15) and a suction chamber (14) are formed between the cathode arrangement (10) and the vacuum pump (11).

14. Device according to claim 13,
**characterised in that** the at least one slit (15) is formed between an angle element (16) connected to a covering plate (12), and a wall (21) of the cathode arrangement (10).

15. Device according to one of claim 4,
**characterised in that** an arrangement (17) forming at least one slit (15) and a suction chamber (14) is arranged in the pump chamber (P1, P2).

16. Device according to claim 15,
**characterised in that** the arrangement (17) takes the form of a box.

17. Device according to claim 16,
**characterised in that** the arrangement (17) exhibits side plates (18) and a cover (19).

18. Device according to claim 17,
**characterised in that** the slits (15) are formed between the cover (19) and the inwardly curved side plates (18).

19. Device according to claim 18,
**characterised in that** the slits (15) are oriented in the direction of the walls (6) of the pump chamber (P1).

20. Device according to claim 19,
**characterised in that** the arrangement (17) is constructed of two angle plates (20).

21. Device according to claim 20,
**characterised in that** the angle plates (20) are separated from one another by a slit (15).

22. Device according to claim 21,
**characterised in that** the slit (15) between the angle plates (20) is oriented in the direction of the substrate (2).

## Revendications

1. Dispositif (1) pour le revêtement d'un substrat (2), comprenant une chambre à vide (5), au moins une structure de cathode (10) disposée dans la chambre à vide (5) et au moins une pompe à vide (11) étant en liaison avec la chambre à vide (5), un espace d'aspiration (14) étant formé entre la au moins une pompe à vide (11) et la chambre à vide (5),
**caractérisé**
**en ce que** l'espace d'aspiration (14) s'étend perpendiculairement à une direction de transport (T) du substrat (2), l'espace d'aspiration (14) étant en liaison avec la chambre à vide (5) étranglé par l'intermédiaire d'au moins un endroit d'étranglement, et
**en ce que** l'endroit d'étranglement est formé par au moins une entaille (15) s'étendant perpendiculairement par rapport à la direction de transport du substrat (2), l'entaille (15) étant réglable de sorte qu'un effet d'étranglement apparaît, lequel a pour effet une homogénéisation de la distribution de gaz dans la chambre à vide (5).

2. Dispositif selon la revendication 1,
**caractérisé**
**en ce que** la chambre à vide (5) est partagée en plusieurs sections (3).

3. Dispositif selon la revendication 2,
**caractérisé,**
**en ce qu'**au moins une des sections (3) est formée comme une chambre de pulvérisation cathodique (S).

4. Dispositif selon la revendication 2 ou 3,
**caractérisé,**
**en ce qu'**au moins une des sections (3) est formée comme une chambre de pompe (P1, P2).

5. Dispositif selon l'une des revendications 2 à 4,
**caractérisé,**
**en ce que** les sections (3) sont séparées les unes des autres par des parois (6).

6. Dispositif selon la revendication 5,
**caractérisé,**
**en ce que** les parois (6) présentent des ouvertures (4).

7. Dispositif selon l'une des revendications 1 à 6,
**caractérisé,**
**en ce que** l'espace d'aspiration (14) s'étend sur une largeur totale de la chambre à vide (5).

8. Dispositif selon la revendication 1,
**caractérisé,**
**en ce que** la au moins une rainure (15) s'étend sur une largeur totale de l'espace d'aspiration (14).

9. Dispositif selon l'une quelconque des revendications 1 à 8,
**caractérisé,**
**en ce que** la au moins une pompe à vide (11) est fixée sur au moins une plaque de couverture (12).

10. Dispositif selon la revendication 9,
**caractérisé,**
**en ce que** la au moins une plaque de couverture (12) recouvre à chaque fois une ouverture d'aspiration (13) dans un couvercle (7) de la chambre à vide (5).

11. Dispositif selon la revendication 10,
**caractérisé,**
**en ce qu'**un élément d'angle (16) est formé sur la au moins une plaque de couverture (12).

12. Dispositif selon la revendication 11,
**caractérisé,**
**en ce que** l'élément d'angle (16) pénètre dans l'ouverture d'aspiration correspondante (13).

13. Dispositif selon la revendication 3,
**caractérisé,**
**en ce que** dans la chambre de pulvérisation cathodique (S) la structure de cathode (10) est disposée de sorte qu'il est formé au moins une rainure (15) et un espace d'aspiration (14) entre la structure de cathode (10) et la pompe à vide (11).

14. Dispositif selon la revendication 13,
**caractérisé,**
**en ce que** la au moins une rainure (15) est formée entre un élément d'angle (16) lié à une plaque de couverture (12) et une cloison (21) de la structure de cathode (10).

15. Dispositif selon la revendication 4,
**caractérisé,**
**en ce que** dans la chambre à pompe (P1, P2) est disposée une structure (17) avec la formation d'au moins une rainure (15) et d'un espace d'aspiration (14).

16. Dispositif selon la revendication 15,
**caractérisé,**
**en ce que** la structure (17) est formée dans la forme d'une armoire.

17. Dispositif selon la revendication 16,
**caractérisé,**
**en ce que** la structure (17) présente des tôles latérales (18) et un couvercle (19).

18. Dispositif selon la revendication 17,
**caractérisé,**
**en ce que** les rainures (15) sont formées entre le couvercle (19) et les tôles latérales courbées vers l'intérieur (18).

19. Dispositif selon la revendication 18,
**caractérisé,**
**en ce que** les rainures (15) sont orientées dans la direction des parois (6) de la chambre à pompe (P1).

20. Dispositif selon la revendication 19,
**caractérisé,**
**en ce que** la structure (17) est constituée de deux tôles d'angle (20).

21. Dispositif selon la revendication 20,
**caractérisé,**
**en ce que** les tôles d'angle (20) sont éloignées les unes des autres par une rainure (15).

22. Dispositif selon la revendication 21,
**caractérisé,**
**en ce que** la rainure (15) est orientée entre les tôles d'angle (20) dans la direction du substrat (2).
